# EUROPEAN PATENT APPLICATION

(11) **EP 3 879 631 A1**
(43) Date of publication of application: **15.09.2021**
(21) Application number: 21161653.7
(22) Date of filing: 10.03.2021
(51) Int. Cl.: H01R 4/26, H01R 4/64, H01R 9/05

(54) **SECURING SLEEVE WITH POSITIVE LOCKING ELEMENTS**

(30) Priority: 11.03.2020 DE 102020203158
(71) Applicant: TE Connectivity Germany GmbH, 64625 Bensheim (DE)
(72) Inventor: HASPEL, Michael, 64625 Bensheim (DE); ECKEL, Markus, 64625 Bensheim (DE)
(74) Representative: Grünecker Patent- und Rechtsanwälte PartG mbB

(57) **Abstract**

The invention relates to a securing sleeve (1) for securing a contacting between an electric conductor (56) and a shielding contact (68). The securing sleeve (1) comprises a securing section (2) with a bottom (6) located between two wings (4) for supporting the electric conductor (56), wherein in an open state (8) before the fastening to the electric conductor (56), the wings (4) are spaced apart by a slot (12) extending in an axial direction (X) at their free ends (10) facing away from the bottom (6), and wherein the wings (4) are provided with complementary positive locking elements (14) at their free ends (10) which secure the securing sleeve (1) in a closed state (55).

## Description

The invention relates to a securing sleeve for contacting a shield of an electric conductor at a shielding contact.

Securing sleeves of the type mentioned above are already known from prior art. They are used, for example, in electric vehicles for high voltage applications. The securing sleeve may be pushed over the shield and then clamp the shield between the securing sleeve and the shielding contact, for example by a crimping process, so that a constant contacting may take place even with high vibrating loads. In particular in high-voltage applications, it is important that high shielding currents can be conducted through the shielding device without major transition resistances. The securing sleeve is in most cases essentially cylindrical and is pushed onto the electric conductor. In particular with long conductor pieces, this can lead to high assembly efforts. Furthermore, many further process steps are required before the securing sleeve can be finally crimped.

It is therefore an object of the invention to provide a securing sleeve which may be fastened to the electric conductor without high efforts.

This object is achieved by a securing sleeve according to the invention comprising a securing section with a bottom located between two wings for supporting the electric conductor, wherein in an open state before the fastening to the shield, the wings are spaced apart at their free ends facing away from the bottom by a slot extending in an axial direction, and wherein the wings are provided with complementary positive locking elements at their free ends which secure the securing sleeve in a state closed in the circumferential direction.

By the solution according to the invention, the electric conductor may be inserted in the radial direction through the slot between the two wings after the necessary process steps have been accomplished. Consequently, the securing sleeve can be inserted directly at the site where it is to be closed around the shield and does not have to be pushed over a possibly long section of the electric conductor. By the complementary positive locking elements, the securing sleeve may be secured in the closed state. A securing by a mainly plastic deformation, as it is the case, for example, in crimping, is no longer required for securing the securing sleeve in the closed state. Consequently, it can be prevented that the free ends cut into the shield, and the securing sleeve can be easily reopened, for example for an exchange.

Below, further developments will be given which can be arbitrarily combined with each other independently and are each advantageous taken alone.

For example, the securing sleeve may be in particular not crimped in the closed state. Preferably, the complementary positive locking elements may not be crimped to each other in the closed state. Therefore, by the securing sleeve, the repairability of a contact arrangement can be improved compared to a contact arrangement with a crimp sleeve. With a crimped contact arrangement, in case of a malfunction or false position of the crimp sleeve, the complete exchange of the contact arrangement would be necessary. Since the securing sleeve is not crimped in the closed state it can be easily reopened. Consequently, the securing sleeve can be easily exchanged in a contact arrangement.

The complementary positive locking elements may be interlocked under tensile stress in the closed state. The positive locking elements can compensate an elastic restoring force between the two wings in the closed state, wherein the securing sleeve will be opened by the elastic restoring force at least in sections by releasing the lock. Thereby, the exchange of the securing sleeve in a contact arrangement may be further facilitated.

The securing sleeve may be elastically deformable, wherein the securing sleeve is in a non-deformed state in a starting position in an open state, and is elastically deformed at least in sections in the closed state. The elastic deformation may be secured by the complementary positive locking elements.

The securing sleeve may be deformed merely elastically in the closed state, whereby, after the release of the lock of the complementary positive locking elements, the securing sleeve will return to its non-deformed state in the starting position by the elastic restoring force.

Preferably, the securing sleeve can comprise, in addition to an elastically deformed section, a plastically deformed section in its closed state. For example, at least the bottom may be plastically deformed, and at least one section of the wings, in particular the free ends of the wings, may be elastically deformed. Via the elastically deformed section, a normal contact force can be generated by the securing sleeve and act onto the shield and the shielding contact. Thus, a sufficient normal contact force for contacting the shield with the shielding contact may be achieved by the securing sleeve.

Since the securing sleeve should not be crimped, the securing sleeve may have a lower strength, in particular material thickness, compared to a crimp sleeve. For example, the securing sleeve may be formed of a thinner material as compared to a crimp sleeve. The securing sleeve may be provided for an electric conductor of a predetermined diameter and may have a lower strength, in particular material thickness, compared to a crimp sleeve standardised for the electric conductor of a predetermined diameter. Thereby, material costs can be saved, and the weight of the securing sleeve can be reduced.

According to a further advantageous embodiment, the securing sleeve may be provided with a profiled surface at least in sections. For example, a radial inner surface of the securing sleeve may comprise, at least in sections, a serration, a honeycomb structure, a micro-structure, or the like. By the profiled surface, an increased surface roughness may be achieved which can avoid a slipping of the securing sleeve along the electric conductor.

The slot can have, for example, in the opened state a width in the circumferential direction between the free ends of the wings that is larger than a predetermined diameter of the electric conductor, at least in the region of the shield. Thereby, the electric conductor can be easily inserted into the securing sleeve without getting caught at the free ends of the wings. Thereby, above all the susceptibility of failures in an automated assembly may be reduced.

At least one wing may comprise an in particular cantilevered, radially projecting latching tab provided with a positive locking element. By the cantilevered latching tab, the at least one positive interlocking element can be deflected and, for example during closing, be easily pushed over or under the complementary positive locking element.

The radially projecting latching tab may form, for example, a section of the free end or else the whole free end. In other words, the free end of at least one wing may be formed as a cantilevered, radially projecting latching tab. If both wings are provided with radially projecting latching tabs, the latching tab of the one wing may be further deflected to the outside in the radial direction than the other latching tab, so that they can radially overlap, at least in the closed state.

Preferably, the at least one latching tab may comprise a section that is straight at least in the open state, and that overlaps with the free end of the other wing in the closed state. For example, the free end may rest on the straight section of the at least one radially projecting latching tab in the closed state, or vice versa. This can prevent the securing sleeve from projecting far into the radial direction in the closed state. Furthermore, the overlap can prevent the element that is located radially inside in the closed state from pivoting radially to the outside, for example by vibrating loads.

The positive locking element may be preferably arranged at the free end of the at least one radially projecting latching tab. For example, the at least one latching tab may be provided with a latching hook radially projecting to the inside. The free end of the latching hook can radially face inwards. Preferably, the latching hook is not bent back in the circumferential direction so that no cavity will form into which the complementary positive locking element can be inserted. Therefore, the complementary positive locking element does not have to be initially moved over and beyond the free end of the latching hook in the circumferential direction to hook on in the cavity. Thereby, the securing sleeve would have to be compressed more during the closing operation than in the closed state. Consequently, a load of the electric conductor or the shielding contact during the closing operation by the securing sleeve may be too high, whereby the components could be possibly damaged. It can furthermore be prevented that the contact force in the closed state, which acts from the securing sleeve onto the shield and/or the shielding contact, is too low.

At least one latching tab may be arranged between two fingers extending in parallel in the circumferential direction. The fingers and the latching tab can form the free end of one wing. Preferably, the fingers and the latching tab may be of equal length in the circumferential direction, so that they essentially limit the slot on a radial plane in the open state.

The at least one latching tab may be, for example, a strip punched out of the free end of the wing between the two fingers which is on the one hand connected with its base to the remaining part of the wing, and which extends from the base at an inclined angle in the radial direction to the outside. The base may be a hinge, in particular an integral hinge, about which the latching tab is rotatably connected with the remaining part of the wing.

By the latching tab being deflected to the outside with its free end relative to the fingers in the radial direction, a gap opened towards the slot in the open state may be formed between the latching tab and the finger. In the closed state, the opposite wing may be inserted in the gap between the fingers and the at least one latching tab. Thereby, the opposite wing, in particular the opposite free end, may be arranged in the radial direction between the wings and the at least one latching tab.

The fingers may preferably comprise one latching projection each which is directed against the latching hook of the at least one latching tab. Thereby, the complementary positive locking element can, in the closed state, simultaneously form a positive locking with the latching hook and the latching projections, thus providing additional retention if the connection at the latching hook or at the latching projections gets disengaged.

The latching projections of the respective fingers can be arranged at one level in the circumferential direction. Preferably, the latching projections may be arranged in the circumferential direction offset relative to the latching hook to engage in a positive locking with the complementary positive locking element at various sites. The complementary positive locking element can be, for example, a broad latching tab extending across the total width of the wing in the axial direction. Thus, this latching tab may simultaneously contact the fingers and the latching tab of the other wing.

The broad latching tab of the other wing can be inserted in the gap between the fingers and the latching tab of the first wing so that the latching hook of the broad latching tab and the latching projections of the fingers engage. According to an advantageous embodiment, the latching projections of the fingers and the latching hook of the broad latching tab may grip behind each other in the closed state and abut against each other with their outer surfaces facing each other in a flat manner. The latching tab can rest on the radial outer surface of the broad latching tab wherein the latching hook of the latching tab grips behind a straight section of the broad latching tab and abuts against a slope section of the broad latching tab.

For the securing sleeve to be able to abut around the shield as flatly as possible in the closed state, a section of the one wing may have an offset radially to the outside. Preferably, the free end of the one wing may be radially offset to the outside relative to the remaining part of the wing. The offset may approximately correspond to the material thickness of the opposite wing, in particular the free end thereof. In the closed state, the section of the opposite wing may abut against the offset section radially inside. In order for the opposite wing to be able to take a region of the offset as large as possible in the closed state, the section may be offset in steps relative to the remaining part of the wing.

According to a further advantageous embodiment, at least one wing may comprise at least one rigid latching nose projecting in the radial direction at which the positive locking element is formed. "Rigid" means here that the latching nose may be elastically deflectable less compared to the at least one latching tab. This can be realised, for example, in that the at least one latching nose is fastened to the remaining part of the wing in the circumferential direction on either side. That means, the latching nose may be embodied in a non-cantilevered manner.

The at least one latching nose may comprise a guide bevel directed towards the opposite wing where the opposite positive locking element, in particular a latching tab, can slide along during the closing operation to be pushed over and beyond the latching nose. The guide bevel may be inclined radially to the outside from the opposite wing in the circumferential direction. A straight surface section of the latching nose may follow the radially exterior end of the guide bevels so that the opposite positive locking element may flatly abut against the straight surface section in the closed state.

The straight surface section may end in a step radially directed to the inside in the circumferential direction away from the opposite wing, by which step the latching nose is connected to the remaining wing. Thereby, a stop face essentially directed in the radial direction, against which the opposite positive locking element abuts in the closed state and which prevents an opening of the securing sleeve at least by a positive lock, may be formed.

According to a further advantageous embodiment, the complementary positive locking elements of the wings may be mutually pressed at least in sections in the closed state. Thereby, a plastic deformation can take place which prevents the positive locking elements from unintentionally getting released under the action of a load, in particular by vibrating loads. By the combination of the plastic and elastic deformations during the closing operation, a stable fastening to the electric conductor can be ensured, wherein the securing sleeve may be reopened if required.

If the securing sleeve is to be additionally fastened to a further section of the electric conductor, for example to its insulation, the securing sleeve may comprise a further securing section with two further wings extending away from the bottom in the circumferential direction which is spaced apart from the securing section in the axial direction, wherein the free ends of the further wings are spaced apart by the slot extending in the axial direction in an opened state. The further wings may also be provided with complementary positive locking elements which secure the securing sleeve in the closed state.

The securing section and the further securing section can be provided for different regions of the electric conductor with different predetermined diameters. Therefore, it may be advantageous for the securing section and the further securing section to enclose different predetermined diameters in the closed state. This can be realised, for example, in that the wings of the first securing section and the wings of the further securing section have different lengths in the circumferential direction and/or curvatures at least in the open state.

The bottom may taper in a web section between the two securing sections in the radial direction whereby the difference in the diameter of the electric conductor in the securing section and in the further securing section may be compensated, or an offset may be formed. If the diameter of the electric conductor with the shield being exposed is larger, for example by inserting an inner support sleeve of a shielding contact under the shield, than in a region with the insulation, the bottom in the web region may radially taper from the securing section towards the further securing section.

The wings of the first contact section and the further wings of the further contact section may have different or also the same positive locking elements. Preferably, the wings of the respective securing sections may be designed such that the securing sleeve can be closed in one common step.

To ensure a production as simple as possible, in particular in a large-scale manufacture, the securing sleeve can be integrally manufactured as a monolithic component. The securing sleeve can preferably be a punched and bent part, whereby a plurality of securing sleeves can be formed to one individual support strip.

The securing sleeve may be formed of an electrically conductive material. Thereby, apart from securing the shielding contacting for electromagnetic compatibility, a high shielding current may furthermore be conducted through the securing sleeve.

As an alternative, the securing sleeve may also be formed of an electrically non-conductive material. The securing sleeve may be formed of plastic, for example as a moulded part.

A contact arrangement may comprise an electric conductor with a shield, a shielding contact, and an inventive securing sleeve according to one of the preceding embodiments.

The contact arrangements may be designed, for example, to transmit up to approximately 50% of the rated current of the electric conductor.

The securing sleeve can be closed with its securing section around a region of the electric conductor where the shield is exposed. If the securing sleeve has a further securing section, the further securing section may be closed around a region of the electric conductor with an insulation. Thus, the securing sleeve can be rigidly fixed with the electric conductor. A shielding contact may be pushed under the shield at least in sections, so that the shielding contact may be contacted by the pressing force acting from the securing sleeve onto the shield. The shield can in this case be arranged between the shielding contact and the securing sleeve, in particular clamped between them.

As an alternative, the contact arrangement may also comprise a plurality of securing sleeves which are closed around various regions of the electric conductor. For example, one securing sleeve can be closed around the insulation of the electric conductor, and a further securing sleeve can be closed around the shield of the electric conductor.

The securing sleeve can preferably abut against a lateral surface area of the electric conductor across its complete length in the axial direction.

The electric conductor may be, for example, a cable with a shielding braid and an insulation. The shielding braid may be exposed at one point and be flared, wherein the shielding contact is pushed under the shielding braid at least in sections. The electric conductor can be unipolar or multipolar, for example. For example, the electric conductor may comprise one single conductor wire surrounded by the shield. As an alternative, the electric conductor can also comprise a plurality of conductor wires surrounded by a common shield. The shield can comprise aluminium, copper, or tin-coated copper, for example.

The shielding contact can be an aluminium contact, for example. Of course, the shielding contact can be formed of another, electrically conductive material, for example copper, or else tin-coated copper.

According to a further advantageous embodiment, a support sleeve may be pushed under the shield, in particular the shielding braid. The support sleeve can contribute to the increase in mechanical strength and form a support so that the securing sleeve can be pressed with the shielding braid and the shielding contact during the closing operation. In this case, the shielding contact can also be arranged between the shielding braid and the securing sleeve.

The closing of the securing sleeve may cause a plastic deformation of the shield, wherein the shield is pressed against the shielding contact. The shielding contact can also be plastically deformed in the process. As an alternative, the shielding contact may not be plastically deformed during the closing operation.

Preferably, during the closing operation of the securing sleeve, first a plastic deformation can take place at the bottom, whereby the free ends are pivoted towards each other. Subsequently, the wings may be deflected elastically towards each other, so that the complementary positive locking elements interlock and prevent a return of the wings due to the elastic restoring force.

Here, due to the elastic resilience of the wings, a normal contact force may act from the securing sleeve onto the shield by which the shield is pushed against the shielding contact.

The use of a securing sleeve according to one of the preceding embodiments may lead to a facilitated installation since the securing sleeve does no longer have to be pushed over the electric conductor in the axial direction. The securing sleeve may be inserted directly at the site where it is to be connected to the electric conductor. Consequently, process steps which no longer permit the pushing on of the securing sleeve onto the electric conductor in the axial direction can be performed before the securing sleeve is inserted. Furthermore, in contrast to a cylindrical crimp sleeve, it is possible to reopen the securing sleeve in the closed state, whereby it may be easily replaced.

Below, the invention will be described more in detail by embodiments with reference to the enclosed drawings by way of example. In the figures, elements that correspond to each other concerning their construction and/or function are provided with the same reference numerals.

The combinations of features shown and described in the individual embodiments are only provided for illustration purposes. In accordance with the above statements, a feature of an embodiment may be omitted if its technical effect is not relevant for a certain application. Inversely, in accordance with the above statements, a further feature may be added to an embodiment if its technical effect is advantageous or necessary for a certain application.

In the drawings:
- Fig. 1: shows a schematic perspective view of an exemplary embodiment of a securing sleeve according to the invention in an open state;
- Fig. 2: shows a schematic perspective view of an exemplary embodiment of a contact arrangement according to the invention with the securing sleeve represented in Fig. 1;
- Fig. 3: shows a schematic sectional view of the contact arrangement shown in Fig. 2; and
- Fig. 4: shows a schematic perspective view of the contact arrangement shown in Figs. 2 and 3 in a closed state.

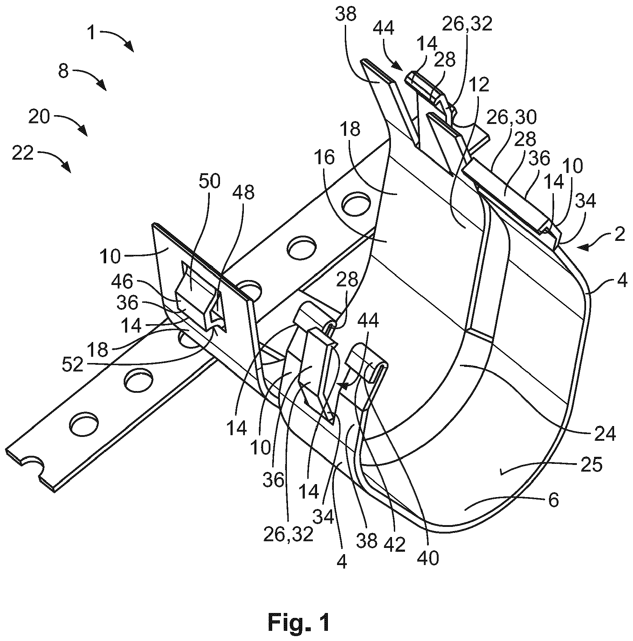

Initially with respect to Fig. 1, an exemplary embodiment of a securing sleeve 1 according to the invention is described.

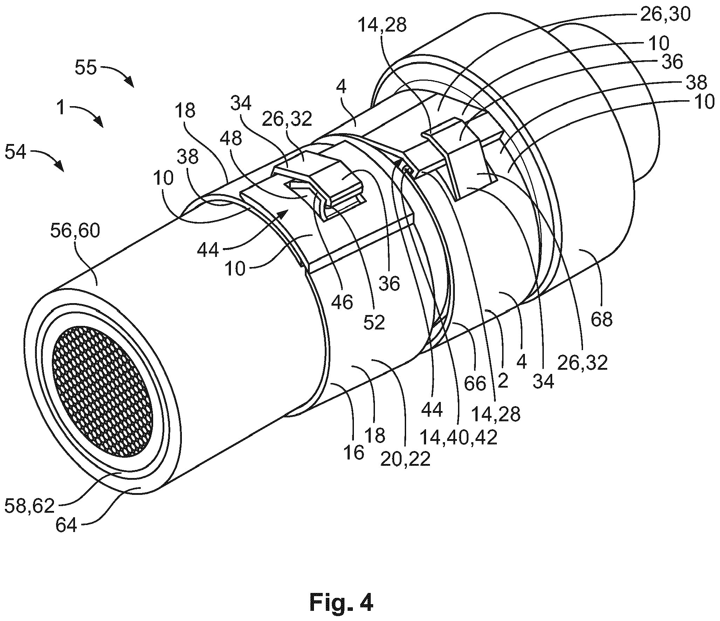

The securing sleeve 1 according to the invention comprises a securing section 2 with a bottom 6 located between two wings 4 for supporting an electric conductor, wherein in an open state 8 before the fastening to the electric conductor, as it is shown in Fig. 1, the wings 4 are spaced apart at their free ends 10 facing away from the bottom 6 by a slot 12 extending in an axial direction X, and wherein the wings 4 are provided with complementary positive locking elements 14 at their free ends 10 which secure the securing sleeve 1 in a closed state (see Fig. 4).

According to this exemplary embodiment, the securing sleeve 1 is to be fastened to various sections of the electric conductor, therefore the securing sleeve 1 may comprise a further securing section 16 spaced apart from the securing section 2 in the axial direction X. The further securing section 16 can also comprise a further pair of wings 18, wherein the further wings 18 extend away from the bottom 6 in the circumferential direction U. Similar to the first securing section 2, the further wings 18 may be spaced apart at their free ends 10 facing away from the bottom 6 in the open state 8 by the slot 12, wherein the further wings 18 may also be provided with complementary positive locking elements 14 at their free ends 10.

The securing sleeve 1 may preferably be integrally designed as a monolithic component 20, for example a punched and bent part 22. This may ensure a fast and inexpensive production, in particular in large scale manufacture. In order to contribute, in addition to the securing of a shielding contacting, to an electromagnetic compatibility of a contact arrangement, the securing sleeve 1 can be formed of an electrically conductive material, for example, aluminium, copper, or else tin-coated copper. Thereby, high shield currents may be conducted through the securing sleeve.

The securing section 2 and the further securing section 16 may be connected to each other via the bottom 6. To this end, the bottom 6 may comprise a web section 24 extending in the axial direction X between the two securing sections 2, 16.

Since the securing sections 2, 16 may be arranged at various sites of the electric conductor, the securing sections 2, 16 may enclose different predetermined diameters at least in the closed state. To this end, the wings 4 of the securing section 2 may comprise different curvatures and/or lengths compared to the further wings 18 of the further securing section 16, and vice versa.

The securing sections 2, 16 can be offset with respect to each other in the radial direction. This may be realised, for example, in that the web section 24 radially tapers in the axial direction from the web section 2 to the further web section 16.

As an alternative, the contact arrangement may also comprise a plurality of securing sleeves 1 which are closed around various regions of the electric conductor. For example, a securing sleeve 1 can be closed around the insulation of the electric conductor, and a further securing sleeve 1 can be closed around the shield of the electric conductor (not shown).

According to a further advantageous embodiment, the securing sleeve 1 may be provided with a profiled surface at least in sections (not shown). For example, a radial inner surface 25 of the securing sleeve may comprise, at least in sections, a serration, a honeycomb structure, a micro-structure, or the like. By the profiled surface, an increased surface roughness may be achieved which can avoid a slipping of the securing sleeve along the electric conductor.

Below, the complementary positive locking elements 14 of the securing section 2 will be described. The further wings 18 of the further securing section 16 can comprise, of course, the same positive locking elements 14 as the wings 4 of the securing section 2.

At least one wing 4 can be provided with at least one radially projecting latching tab 26. The at least one latching tab 26 can in particular be cantilevered, whereby an elastic deflection of the at least one latching tab 26 is promoted. The at least one radially projecting latching tab 26 can be provided with a positive locking element 14. The positive locking element 14 can be a latching hook 28 radially projecting to the inside, for example. Preferably, the latching hook 28 can be arranged at a free end of the latching tab 26.

As can be seen in Fig. 1, the radially projecting latching tab 26 can form a section of the free end or else extend across the complete width in the axial direction X of the free end 10 and form the free end 10 itself. According to the exemplary embodiment in Fig. 1, a wing 4 may comprise a broad latching tab 30 forming the free end 10 of the wing 4, and the other wing 4 can comprise a narrow latching tab 32 forming a section in the axial direction X of the free end 10 of the wing 4.

The broad latching tab 30 and the narrow latching tab 32 can be deflected in the radial direction to different degrees in the open state so that during the closing operation, one latching tab 26 may slide over and beyond the other latching tab 26. In this exemplary embodiment, the narrow latching tab 32 is deflected in the radial direction further to the outside than the broad latching tab 30.

The latching tab 26 can comprise a slope section 34 by which the latching tab 26 is connected to the remaining wing 4 and which extends to the outside in the radial direction, and a support section 36 adjacent to the slope section 34 to rest at the other wing 4 in the closed state. The support section can preferably be straight so that the latching tab 26 can flatly rest against the other wing in the closed state. Preferably, the broad latching tab 30 and the narrow latching tab 32 may each be provided with complementary support sections 36, wherein in the closed state, the narrow latching tab 32 rests on the support section 36 of the broad latching tab 30 with its support section 36. The latching hook28 of the narrow latching tab 32 projecting radially to the inside may abut against the slope section 34 of the broad latching tab 30, whereby the narrow latching tab 32 grips behind the broad latching tab 30 in the circumferential direction U and thus prevents an opening of the wings 4 in the circumferential direction U by a positive lock. Furthermore, by the support of the narrow latching tab 32 on the broad latching tab 30, it may be prevented that the broad latching tab 30 is radially moved to the outside in the closed state, for example, by vibrating loads.

A free end of the latching hook 28 preferably faces radially to the inside, wherein no cavity between the latching tab and the free end of the latching hook 28 is formed. This can prevent the positive lock from being formed in the cavity, which can result in excessive squeezing during the closing operation or a contact force that is too weak in the closed state.

The narrow latching tab 32 can be arranged in the axial direction X between two fingers 38 extending in the circumferential direction U in parallel to each other. The fingers 38 may thus form the remaining part of the free end 10 of this wing 4. The fingers 38 may each be provided with a further positive locking element 14, for example in the form of a latching projection 40. The respective latching projection 40 can be directed against the latching hook 28 of the narrow latching tab 32, in particular, the respective latching projection 40 can be directed against the latching hook 28 of the broad latching tab 30, so that the latching hook 28 of the broad latching tab 30 and the respective latching projections 40 are engaged, in the closed state, with their outer surfaces facing away from the opposite wing in the circumferential direction U, so that a positive lock is formed in the circumferential direction U which prevents the opening of the securing sleeve 1.

The outer surface of the respective latching projection 40 and of the latching hook 28 of the narrow latching tab 32 can be arranged offset with respect to each other in the circumferential direction U, so that they are engaged with the broad latching tab 30 in a positive lock at different sites of the broad latching tab 30 in the circumferential direction U. The respective latching projection 40 can be formed, for example, by bending back the free end of the respective finger 38. Here, the bent back end 42 of the finger 38 can abut against the remaining finger 38 so that here, no cavity is formed neither.

The narrow latching tab 32 may be offset in the radial direction to the outside relative to the fingers 38, so that at least between the free ends of the latching tab 32 and the finger 38, a gap 44 is formed which is opened towards the slot 12 in the open state 8. The gap 44 can correspond, in particular in the radial direction between the latching projections and the latching hook 28 of the at least one narrow latching tab 32, at least to the material thickness in the radial direction of the broad latching tab 30 of the other wing 4, so that the broad latching tab 30 can be inserted into the gap 44 during the closing operation. Consequently, the wings 4 may overlap at least in sections in the closed state.

For the securing section 2 of the securing sleeve 1 to be able to lie around the shield as flatly as possible in the closed state, the broad latching tab 30 may be offset radially to the outside relative to the fingers 38. At least the support section 36 of the broad latching tab 30 can comprise an offset relative to the latching projections 40 of the fingers 38 which essentially corresponds to the thickness of the fingers 38 in the radial direction at the site with the latching projections, so that the latching projections 40 may abut against a radial inner surface of the broad latching tab 30 in the closed state. Consequently, an annular inner contour as uniform as possible can be produced in the closed state, whereby the shield may be contacted as uniformly as possible.

Now, a further embodiment of a positive locking arrangement will be described with reference to the further securing section 16.

One wing 18 can comprise, as described above, a narrow cantilevered latching tab 26 radially projecting to the outside which is arranged in the axial direction X between two fingers 38. In contrast to the fingers 38 in the securing section 2, the fingers 38 do not comprise any latching projections in the further securing section 16. Consequently, in this embodiment, a positive lock is only produced over the narrow latching tab 26.

Opposed to the narrow latching tab 26, the other wing 18 may have a complementary latching nose 46. The latching nose 46 may project to the outside in the radial direction and have a higher stiffness compared to the narrow latching tab 26. Higher stiffness means that the latching nose 46 can be elastically deflected to a lesser degree than the latching tab 26 of the opposite wing.

To increase the stiffness of the latching nose 46, the latching nose 46 may be fixed to the remaining wing 18 at both ends located in the circumferential direction. The latching nose 46 can be, for example, a punched-out part of the wing 18, wherein it is arranged in a window 48 radially penetrating the wing 18 and is fixed to the frame of the window 48 with its ends. The latching nose 46 has approximately the same width in the axial direction as the latching nose 26 at the other wing 18.

The latching nose 46 can be provided with a guide bevel 50 at a side facing the other wing 18 which is inclined away from the other wing 18 radially to the outside in the circumferential direction U. The latching tab 26 of the other wing 18 can consequently slide along the guide bevel during the closing operation and finally be pushed over the latching tab 26.

The guide bevel 50 is followed by a straight support section 36 in the circumferential direction U away from the other wing 18 on which support section the latching tab 26 may rest with its support section 36 in the closed state. The support section 36 can descend radially to the inside in steps at its end facing away from the opposite wing 18, so that a radially directed stop face 52 facing away from the opposite wing 18 is formed against which the latching hook 28 of the latching tab 26 can abut in the closed state and thus may prevent a relative movement of the further wings 18 in a direction apart from one another by a positive lock.

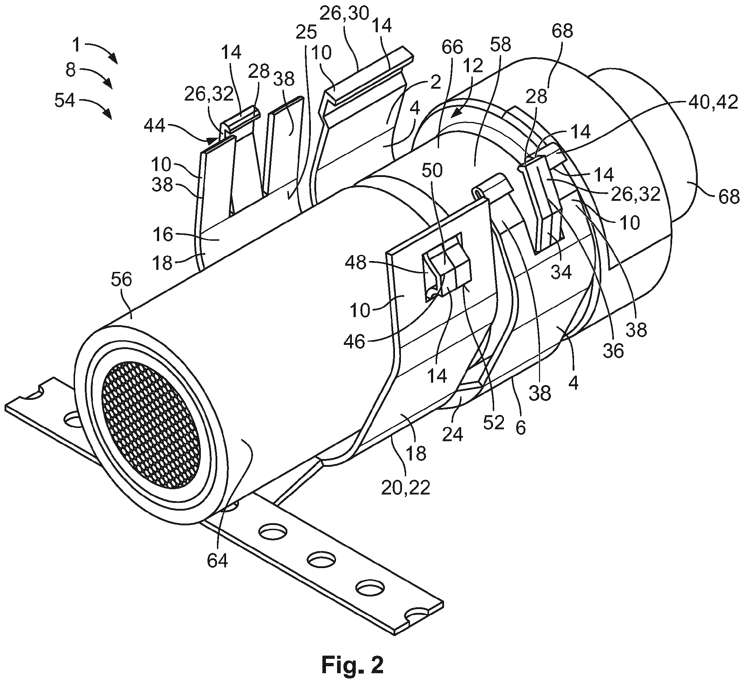

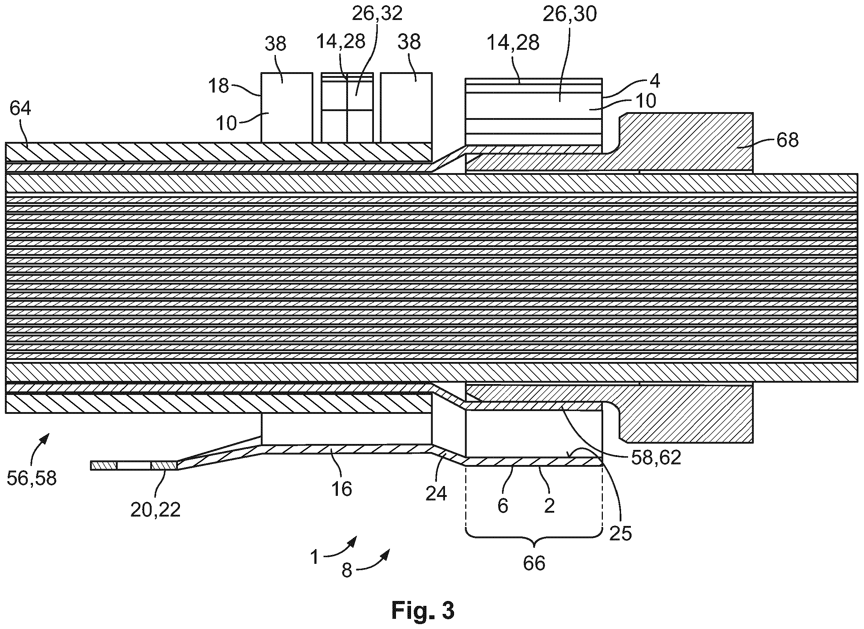

Below, a contact arrangement 54 will be illustrated more in detail with reference to Figs. 2 to 4. In Fig. 2 and Fig. 3, the contact arrangement 54 is shown with a securing sleeve 1 in an open state 8 in a schematic perspective view and a schematic sectional view, respectively. In Fig. 4, the contact arrangement 54 is shown in a closed state 55 of the securing sleeve 1 in a schematic perspective view.

The exemplary embodiment of the contact arrangement 54 according to the invention comprises an electric conductor 56 with a shield 58 and a securing sleeve 1 according to the embodiment represented in Fig. 1. The electric conductor 56 can in particular be an electric cable 60 with a shielding braid 62 and an insulation 64 enveloping the shielding braid 62, the shielding braid 62 being exposed from the insulation 64 in a contacting region 66. The shielding braid 62 can be flared in the contacting region 66, so that a shielding contact 68 for contacting the shielding braid 62 can be pushed under the shielding braid (see Fig. 3).

The securing sleeve 1 is arranged with its securing section 2 at the contacting region 66, so that the securing sleeve 1 presses the shielding braid 62 against the shielding contact 68 in the closed state 55 and thus secures the contacting between both components.

The further securing section 16 is arranged in the region of the insulation 64, so that the securing sleeve 1 may be additionally fastened to the insulation 64 via the further securing section 16.

As can be seen in Fig. 4, the wings 4 and/or the further wings 18 overlap in the closed state 55. Preferably, the overlapping ends are pressed against each other, so that in addition to the securing of the securing sleeve by means of positive locking elements 14, the wings 4 or the further wings 18, respectively, are held together by a plastic deformation. This can avoid that, for example, the latching tabs 26 are deflected radially to the outside.

By the pressing, an offset may be formed at one wing radially to the outside, as can be seen in the further securing section 16. The section of the wing 18 received in the gap 44 rests on the fingers 38 of the other wing 18, wherein during the pressing operation, the non-received part of the wing 18 is pressed against the electric conductor 56. Thus, an offset having the material thickness of the fingers is automatically generated between the wings 18. Consequently, the securing sleeve 1 can rest with its further securing section 16 as uniformly as possible on the surface area of the electric conductor and contact the same.

The securing sleeve 1 may in particular not be crimped in the closed state 55. Preferably, the complementary positive locking elements 14 may not be crimped to each other in the closed state 55. Therefore, by the securing sleeve 1, the repairability of the contact arrangement 54 can be improved compared to a contact arrangement with a crimp sleeve. Since the securing sleeve 1 is not crimped in the closed state it can be easily reopened. Consequently, the securing sleeve 1 can be easily exchanged in a contact arrangement 55.

The complementary positive locking elements 14 may be interlocked under tensile stress in the closed state 55. The positive locking elements can compensate an elastic restoring force between the two wings 4 in the closed state 55, wherein the securing sleeve 1 is at least in sections opened by the elastic restoring force by releasing the lock. Thereby, the exchange of the securing sleeve 1 in a contact arrangement 55 may be further facilitated.

The securing sleeve 1 may be elastically deformable, wherein the securing sleeve 1 is in a non-deformed state in a starting position in an open state 8 (see Figs. 1 to 3), and is elastically deformed at least in sections in the closed state. The elastic deformation may be secured by the complementary positive locking elements.

The securing sleeve 1 may be deformed merely elastically in the closed state 55, whereby, after the release of the lock of the complementary positive locking elements 14, the securing sleeve 1 will return to its non-deformed state in the starting position by the elastic restoring force.

Preferably, the securing sleeve 1 can have, in addition to an elastically deformed section, a plastically deformed section in its closed state. For example, at least the bottom 6 may be plastically deformed, and at least one section of the wings 4, in particular the free ends 10 of the wings 4, may be elastically deformed. Via the elastically deformed section, a normal contact force may be generated by the securing sleeve 1 and act onto the shield 58 and the shielding contact. Thus, by the securing sleeve 1, a sufficient normal contact force for contacting the shield 58 with the shielding contact 68 may be achieved.

Since the securing sleeve 1 should not be crimped, the securing sleeve 1 may have a lower strength, in particular material thickness, compared to a crimp sleeve. The securing sleeve may be provided for an electric conductor of a predetermined diameter and may have a lower strength, in particular material thickness, compared to a crimp sleeve standardised for the electric conductor of a predetermined diameter. Thereby, material costs may be saved, and the weight of the securing sleeve 1 can be reduced.

The use of a securing sleeve 1 according to one of the preceding embodiments may lead to a facilitated installation since the securing sleeve 1 does no longer have to be pushed over the electric conductor 56 in the axial direction X. The securing sleeve 1 may be inserted directly at the site where it is to be connected to the electric conductor 56. Consequently, process steps which no longer permit the pushing on of the securing sleeve 1 onto the electric conductor 56 in the axial direction X can be performed before the securing sleeve 1 is inserted. Furthermore, in contrast to a cylindrical crimp sleeve, it is possible to reopen the securing sleeve 1 in the closed state, whereby it may be easily replaced.

### Reference numerals

- 1: securing sleeve
- 2: securing section
- 4: wing
- 6: bottom
- 8: open state
- 10: free end
- 12: slot
- 14: positive locking element
- 16: further securing section
- 18: further wing
- 20: monolithic component
- 22: punched and bent part
- 24: web section
- 25: radial inner surface
- 26: latching tab
- 28: latching hook
- 30: broad latching tab
- 32: narrow latching tab
- 34: slope section
- 36: support section
- 38: finger
- 40: latching projection
- 42: bent-back end
- 44: gap
- 46: latching nose
- 48: window
- 50: guide bevel
- 52: stop face
- 54: contact arrangement
- 55: closed state
- 56: electric conductor
- 58: shield
- 60: cable
- 62: shielding braid
- 64: insulation
- 66: contacting region
- 68: shielding contact

- U: circumferential direction
- X: axial direction

## Claims

1. Securing sleeve (1) for securing a shield (58) of an electric conductor (56) to a shielding contact (68), wherein the securing sleeve (1) comprises a securing section (2) with a bottom (6) located between two wings (4) for supporting the electric conductor (56), wherein in an open state (8) before the securing of the shield (58) to the shielding contact (68), the wings (4) are spaced apart at their free ends (10) facing away from the bottom (6) by a slot (12) extending in an axial direction (X), and wherein the wings (4) are provided with complementary positive locking elements (14) at their free ends (10) which secure the securing sleeve (1) at least in a circumferential direction (U) in a closed state (55).

2. Securing sleeve (1) according to claim 1, wherein in the closed state (55), the securing sleeve (1) is not crimped.

3. Securing sleeve (1) according to claim 1 or 2, wherein the complementary positive locking elements (14) are interlocked under a tensile stress in the closed state (55).

4. Securing sleeve (1) according to one of claims 1 to 3, wherein at least one cantilevered, radially projecting latching tab (28) is provided with a positive locking element (14).

5. Securing sleeve (1) according to claim 4, wherein the at least one latching tab (26) comprises a straight support section (36) by which the at least one latching tab (26) abuts against the other wing (4) in the closed state (55).

6. Securing sleeve (1) according to claim 4 or 5, wherein the at least one latching tab (26) is provided with a latching hook (28) radially projecting to the inside.

7. Securing sleeve (1) according to one of claims 4 to 6, wherein the at least one latching tab (26) extends in the axial direction (X) across the complete length of the wing (4).

8. Securing sleeve (1) according to one of claims 4 to 7, wherein the at least one latching tab (26) is arranged between two fingers (38) of the wing (4) extending in parallel to each other in the circumferential direction (U).

9. Securing sleeve (1) according to claim 8, wherein in the closed state (55), the opposite wing (4) is inserted through a gap (44) between fingers (38) and at least one latching tab (26).

10. Securing sleeve (1) according to claim 8 or 9, wherein the fingers (38) each comprise one latching projection (40) that projects in the opposite direction to the latching hook (28).

11. Securing sleeve (1) according to one of claims 1 to 10, wherein at least one wing (4) comprises at least one rigid latching nose (46) radially projecting to the outside to which a positive locking element (14) is formed.

12. Securing sleeve (1) according to one of claims 1 to 11, wherein the securing sleeve (1) comprises a further securing section (16) with two further wings (18) spaced apart from the securing section (2) in the axial direction (X), the further wings (18) extending away from the bottom (6) and being provided with complementary positive locking elements (14).

13. Contact arrangement (54), comprising an electric conductor (56) with a shield (58), a shielding contact (68) for contacting the shield (58), and a securing sleeve (1) according to one of claims 1 to 12, wherein the shield (58) is clamped to the shielding contact (68) in the closed state (55) of the securing sleeve (1).

14. Contact arrangement (54) according to claim 13, wherein the shield (58) is arranged between the securing sleeve (1) and the shielding contact (68) at least in sections.

15. Use of a securing sleeve (1) according to one of claims 1 to 12 for securing a contacting between an electric conductor (56) and a shielding contact (68).
